# EUROPÄISCHE PATENTSCHRIFT

(11) **EP 1 364 076 B1**
(45) Veröffentlichungstag und Bekanntmachung des Hinweises auf die Patenterteilung: **28.03.2007**
(21) Anmeldenummer: 01996637.3
(22) Anmeldetag: 27.10.2001
(51) Int. Cl.: C23C 16/448, C23C 18/08

(54) **VORRICHTUNG UND VERFAHREN ZUM ZUFÜHREN EINES IN DIE GASFORM GEBRACHTEN FLÜSSIGEN AUSGANGSSTOFFES IN EINEN CVD-REAKTOR**
DEVICE AND METHOD FOR SUPPLYING A CVD REACTOR WITH A LIQUID STARTING MATERIAL ENTERING INTO A GASEOUS PHASE
PROCEDE ET DISPOSITIF POUR ALIMENTER UN REACTEUR DE DEPOT CHIMIQUE EN PHASE VAPEUR EN MATERIAU DE BASE, PASSE DE LA PHASE LIQUIDE A LA PHASE GAZEUSE

(30) Priorität: 20.11.2000 DE 10057491
(43) Veröffentlichungstag der Anmeldung: 26.11.2003
(73) Patentinhaber: Aixtron AG, 52072 Aachen (DE)
(72) Erfinder: STRAUCH, Gerd, 52072 Aachen (DE); LINDNER, Johannes, 52072 Aachen (DE); SCHUMACHER, Marcus, 50771 Kerpen (DE)
(74) Vertreter: Grundmann, Dirk
(86) Internationale Anmeldenummer: PCT/EP2001/014302
(87) Internationale Veröffentlichungsnummer: WO 2002/040739

(56) Entgegenhaltungen:
- EP-A- 1 038 988
- US-A- 548 926
- US-A- 5 451 260
- US-A- 5 835 678
- US-A- 5 887 117
- PATENT ABSTRACTS OF JAPAN vol. 1999, no. 04, 30. April 1999 (1999-04-30) & JP 11 012741 A (NISSIN ELECTRIC CO LTD), 19. Januar 1999 (1999-01-19)

## Beschreibung

Die Erfindung betrifft eine Vorrichtung und ein Verfahren zum Zuführen eines in die Gasform gebrachten flüssigen Ausgangsstoffs in einen CVD-Reaktor, mit einer einen quer in einen Gasströmungskanal mündenden Flüssigkeitskanal aufweisenden Düse zur Bildung eines Aerosols, welches durch Wärmezufuhr verdampft.

Ein derartiges Verfahren bzw. eine Vorrichtung zur Durchführung des Verfahrens zeigt beispielsweise das US-Patent 6,110,531. Dort wird mittels einer Venturi-Düse ein Nebel erzeugt. Für verschiedenartige flüssige Ausgangsstoffe sind dort mehrere jeweils nach dem Venturi-Prinzip arbeitende Zerstäuber vorgesehen. Der von den Zerstäubern erzeugte Nebel wird durch jeweilige Rohrleitungen einem Vergaser zugeführt, wo die Nebeltröpfchen durch Wärmezufuhr in die Gasform gebracht werden. Die Wärmezufuhr erfolgt dort über Kontaktwärme-übertragung an einer Oberfläche.

Die WO 98/31844 zeigt ebenfalls eine Vorrichtung und ein Verfahren zum Zuführen eines in die Gasform gebrachten flüssigen Ausgangsstoffes in einen CVD-Reaktor. Auch dort wird der flüssige Ausgangsstoff zunächst zerstäubt und dann mit einer heißen Oberfläche in Kontakt gebracht, so dass die Nebeltröpfchen verdampfen.

Die US 5,882,416 beschreibt ebenfalls ein LDS (Liquid Delivery System), bei welchem die Flüssigkeit über das Zwischenstadium eines Tröpfchengemisches in eine Gasform gebracht wird.

Die vorbezeichneten Vorrichtungen werden dazu verwendet, um gasförmige Ausgangsstoffe beispielsweise metallorganische Strontium, Barium, Titan, Tantal- oder Bismuth-Verbindungen einem CVD-Reaktor zuzuführen, in welchem die Metallkomponenten auf einer insbesondere monokristallinen Oberfläche unter Ausbildung einer ferroelektrischen Schicht kondensieren. Aufgrund des niedrigen Dampfdrucks des flüssigen Ausgangsstoffes kann dieser nicht problemlos gasförmig transportiert werden. Zudem sind die Zerlegungstemperaturen dieser metallorganischen Verbindungen niedrig, so dass ein Aufheizen der Flüssigkeit zur Erhöhung des Dampfdrucks ungeeignet ist. Das Fenster zwischen Verdarnpfungstemperatur und Zerlegungstemperatur ist sehr gering.

Die bekannten Vorrichtungen haben den Nachteil, dass die Dosierung nur sehr ungenügend reproduzierbar ist. Dies liegt zum einen an den sehr niedrigen Flüssigkeitsströmungen von nur wenigen Millilitern pro Minute. Zum anderen lässt sich die Dampfzufuhr nicht schlagartig ausschalten, da die Verdampfung an einer Oberfläche erfolgt bzw. die Aerosolbildung räumlich getrennt ist von der Verdampfung. Außerdem kann die Flüssigkeit bzw. ein flüssiges Lösemittel, in welchem die metallorganische Verbindung gelöst ist, frühzeitig verdampfen. Dies kann zu einem Zusetzen der Düsen führen.

Der Erfindung liegt daher die Aufgabe zugrunde, Mittel anzugeben, das gattungsgemäße Verfahren bzw. die gattungsgemäße Vorrichtung hinsichtlich der Dosierbarkeit zu verbessern.

Gelöst wird die Aufgabe durch die in den Ansprüchen angegebene Erfindung.

Erfindungsgemäß wird das Verfahren zunächst und im Wesentlichen dadurch weitergebildet, dass die Verdampfungswärme ausschließlich dem Gas entzogen wird. Die Nebeltröpfchen des Aerosols werden dabei möglichst schlagartig einer temperierten Gasatmosphäre ausgesetzt, die die erforderliche Verdampfungswärme liefert, um die Nebeltröpfchen in die Gasform zu überführen. Die Wärmezufuhr erfolgt dabei durch das Temperieren des Gases selbst, welches den Wärmetransport von einer Heizungsoberfläche zum Aerosol vollzieht. Die Nebeltröpfchen treten erfindugnsgemäß nicht mehr in Kontakt mit einer Oberfläche, um daran zu verdampfen. Das Temperieren des Gases kann durch die Wände einer Verdampfungskammer erfolgen, in welche das Aerosol einströmt. Die Kammer ist dann so ausgebildet, dass der Gasstrom so weit frei in Kammer eintritt, dass das Aerosol vor Auftreffen des Gasstromes auf eine Kammerwand vollständig verdampft ist. Alternativ oder in Kombination dazu kann auch vorgesehen sein, dass das durch den Gasströmungskanal strömende Gas selbst temperiert ist. Es strömt dann ein temperiertes Gas an dem Flüssigkeitskanal vorbei. Dieses Gas bildet dort in bekannter Weise einen Unterdruck aus. Die Flüssigkeit wird somit nach dem Venturi-Prinzip vom temperierten Gasstrom mitgerissen und zerreisst in feine Tröpfchen. Diese Nebeltröpfchen verdampfen dann im temperierten Gasstrom, so dass in der Verdampfungskammer im Wesentlichen nur ein gasförmiger Ausgangsstoff vorhanden ist.

In einer Variante der Erfindung ist vorgesehen, dass die Mündung des Flüssigkeitskanals insbesondere pulsweise geöffnet und geschlossen wird. Die Mündung des Flüssigkeitskanals wird bevorzugt durch Kühlung auf einer Temperatur gehalten, bei welcher sich die Flüssigkeit nicht zerlegt. Der Gasstrom strömt auch an der geschlos-senen Mündung des Flüssigkeitskanales vorbei. Sobald der Flüssigkeitskanal geöffnet wird, wird vom insbesondere temperierten Gasstrom die Flüssigkeit aus dem Flüssigkeitskanal herausgesaugt, zerstäubt und unmittelbar danach verdampft. Es ist für bestimmte Anwendungen von Vorteil, wenn die Öffnungszeiten der nur pulsweise geöffneten Mündung des Flüssigkeitskanals länger dauern, als die Geschlossenzeiten. Öffnungslänge und Pulsfolge sind so eingestellt, dass der Gasstrom vor dem Substrat gleichmäßig ist. Dort soll insbesondere eine laminare Strömung herrschen. Der Flüssigkeitsaustritt in den durch den Strömungskanal fließenden Gasstrom wird zufolge dieser Variante ein- und ausgeschaltet. Dies erfolgt schlagartig, so dass eine sehr genaue Dosierung über die Pulsweite bzw. Pulzfrequenz möglich ist. Wenn zudem die Wärmezufuhr nicht über einen Oberflächenkontakt, sondern über das Gas selbst erfolgt, besitzt die Vorrichtung auch keinen Memorie-Effekt.

Die erfindungsgemäße Vorrichtung weist bevorzugt ein oder mehrere Düsen auf, die einer Verdampfungskammer derart zugeordnet sind, dass der jeweilige, das Aerosol erzeugende und transportierende, insbesondere vortemperierten Gasstrom frei in die Verdampfungskammer strömt. Die Verdampfungskammer kann dabei wandbeheizt sein. Es ist aber auch möglich, dass das durch die Düse strömende Gas mittels einer der Düse vorgeordneten Gasheizung vortemperiert wird.

Der Flüssigkeitskanal kann pulsweise öffen- und schließbar sein. Hierzu kann der Flüssigkeitskanal bevorzugt ein Ringspalt sein. Der Flüssigkeitskanal kann dabei eine Konusform haben. Eine Spaltwand dieses konusförmigen Flüssigkeitskanals kann von einem kegelstumpfförmigen Ventilkegel gebildet sein. Bevorzugt ist ferner, wenn der Flüssigkeitskanal von einem ringförmigen Strömungskanal umgeben ist. Dann ergibt sich eine dreidimensionale Venturi-Düse. Die Mündung des Strömungskanals kann auf einen in der Symmetrieachse des Flüssigkeitskanales liegenden, gedachten Punkt gerichtet sein. Die sich dann ergebende Hauptstrahlrichtung entspricht der Symmetrieachse. Es ist ferner von Vorteil, wenn der Verdampfungskammer unmittelbar eine Beschichtungskammer angegliedert ist. Dann können zusätzliche Ventile oder dergleichen entfallen. Die Beschichtungskammer kann von der Verdampfungskammer lediglich durch die die Gasströmung homogenisierende Leitorgane getrennt werden. Die Vernebelungs- und Verdampfungs-Düse mündet dann quasi direkt in die Beschichtungskammer, in welcher ein Substrat liegt, welches zu beschichten ist. In einer bevorzugten Ausgestaltung der Düse ist diese wassergekühlt. Dies hat zur Folge, dass die Flüssigkeit, die sich bei geschlossenem oder offenem Ventil in einer in der Düse angeordneten Ventilkammer befindet auf einer Temperatur gehalten werden kann, die unterhalb der Zerlegungstemperatur der Flüssigkeit liegt. Der Ventilkegel kann sich nur dann von dem ihn umströmenden heißen Gasstrom erwärmen, wenn er in der Offenstellung ist. In seiner Geschlossenstellung liegt er in Flächenkontakt zu dem gekühlten Abschnitt der Düse, so dass die vom Ventilkegel aufgenommene Wärme sofort in die gekühlen Abschnitte abfließen kann. Zur Vermeidung einer schädlichen Erwärmung des Ventilkegels ist es deshalb von Vorteil, wenn die Geschlossenzeiten der Düse größer sind, als die Offenzeiten, und das Ventil nur wenige Millisekunden öffnet.

Ein Ausführungsbeispiel der Erfindung wird nachfolgend anhand beigefügter Zeichnungen erläutert. Es zeigen:

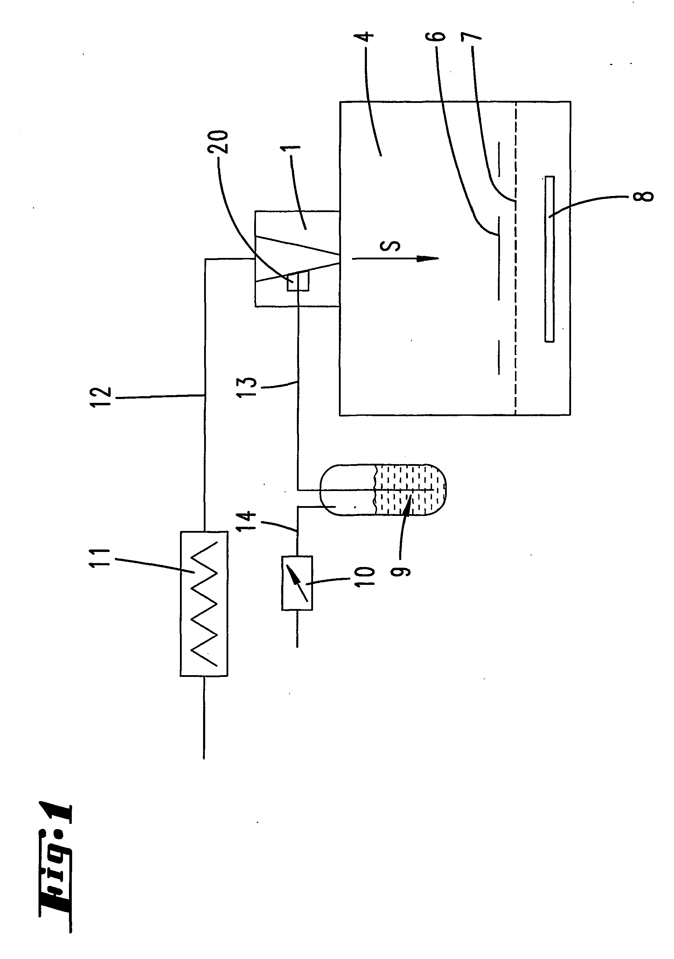

- Fig. 1: den schematischen Aufbau einer erfindungsgemäßen Vorrichtung zur Durchführung des erfindungsgemäßen Verfahrens,
- Fig. 2: eine ebenfalls nur schematisch dargestellte Verdampfungskammer mit angegliederter Beschichtungskammer und der Verdampfungskammer zugeordneten Düsenanordnung und
- Fig. 3: eine vergrößerte Detailansicht einer Düse.

Die Vorrichtung gemäß Ausführungsbeispiel besitzt eine Verdampfungskammer 4, die ein Volumen von etwa zwei Litern besitzt. Die Wände der Verdampfungskammer 4 sind geheizt, so dass sich das in der Verdampfungskammer 4 befindliche Gas auf einer Temperatur (bspw. zwischen 200° bis 250°C) befindet, die zwischen Verdampfungs- und Zerlegungstemperatur liegt. Der Verdampfungskammer 4 schließt sich unmittelbar eine Beschichtungskammer 5 an, in welcher das zu beschichtende Substrat 8 liegt. Die Verdampfungskammer 4 und die Beschichtungskammer 5 sind lediglich durch strömungsleitende Bleche 6 bzw. Gitter 7 voneinander getrennt. Die strömungsleitenden Bleche 6 bzw. Gitter 7 dienen dazu, aus dem aus der Düse 1 tretenden gerichteten Strom S einen möglichst gleichmäßigen Gasstrom von der Verdampfungskammer 4 in die Beschichtungskammer 5 zu erzeugen.

Am oberen Rande der Verdampfungskammer 4 sitzt eine Venturi-Düse 1. In diese Venturi-Düse 1 mündet eine Gaszuleitung 12. In der Gaszuleitung 12 befindet sich eine Heizung 11, die das durch die Gaszuleitung 12 fließende Trägergas aufheizt, so dass es temperiert in die Düse 1 einströmen kann. Nach dem Venturi-Effekt erzeugt der durch die Gaszuleitung 12 tretende Gasstrom an der Mündung der Flüssigkeitszuleitung 13 einen Unterdruck, so dass die Flüssigkeit in die Venturidüse 1 gesaugt wird. Die Mündüng der Flüssigkeitszuleitung 13 kann mittels eines Verschlusses 20 pulsweise geöffnet werden.

Die Flüssigkeitszuleitung verbindet die Düse 1 mit einem Flüssigkeitstank 9. Um die Flüssigkeit aus dem Flüssigkeitstank zu fördern, kann dort durch die Gasleitung 14 ein Gas zugeführt werden, um die Flüssigkeit aus dem Flüssigkeitstank 9 zu verdrängen. Der durch die Gasleitung 14 strömende Gasstrom kann mittels einer Dosiervorrichtung 10 geregelt werden. Der Regler 10 kann aber auch nur ein Druckregler sein.

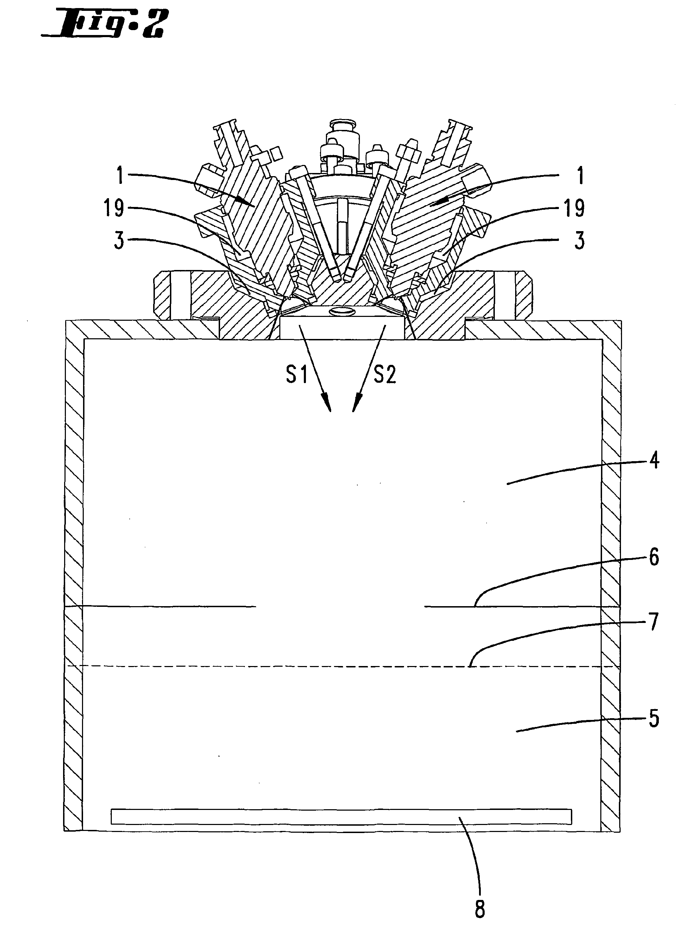

Bei dem in Fig. 2 dargestellten Ausführungsbeispiel sind insgesamt zwei Düsen 1 dargestellt. Es ist aber auch möglich, dass mehrere Düsen einem Düsenkopf zugeordnet sind. Durch jede Düse kann eine andere metallorganische Komponete der Verdampfungskammer 4 zugeführt werden. Die Achsen der Düsen 1 schneiden sich in einem gedachten Punkt. Bei mehreren Düsen liegen die Achsen somit auf einem Kegelmantel.

Die Düsen haben eine Hauptstrahlrichtung S1, S2, die jeweils entlang der Düsenachse gerichtet ist.

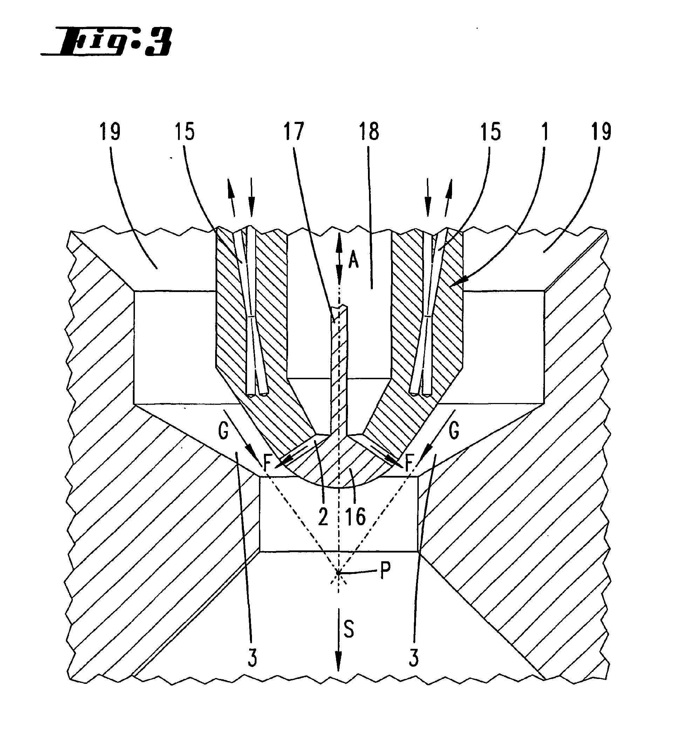

In Fig. 3 sind die wesentlichen Elemente einer Düse 1 vergrößert dargestellt. Die Düse 1 besitzt eine Ventilkammer 18, in welcher sich die Flüssigkeit befindet. Durch die Ventilkammer 18 läuft ein Schaft 17, welcher am Ende einen Ventilkegel 16 besitzt. Dieser Ventilkegel 16 sitzt flächig auf einem konusförmigen Ventilsitz. Die Wandung der Düse 1, der auch der Ventilsitz zugeordnet ist, wird mittels durch Kühlwasserkanäle 15 fließendes Kühlwasser gekühlt.

Der Schaft 17 kann von einem nicht dargestellten Elektromagneten in Richtung des Doppelpfeiles A bewegt werden, so dass der Ventilkegel 16 sich vom Ventilsitz abhebt. Hierdurch bildet sich ein konusförmiger Spalt aus, der den Austrittskanal 2 für die Flüssigkeit bildet. Es bildet sich ein konusförmiger Flüssigkeitsstrom F aus.

Die Außenkontur der Düse 1 hat eine Kegelstumpfform. Der Kegelstumpfmantel der Spitze der Düse 1 wird von einem kegelstumpf förmigen Ringkanal 3 umgeben. Stromaufwärts des ringförmigen Strömungskanales 3 befindet sich eine Ringkammer 19, die zur gleichmäßigen Gasverteilung des durch die Gaszuleitung 12 zugeführten Gases dient. Es bildet sich ein konusförmiger Gasstrom G aus, welcher auf einen gedachten Punkt P gerichtet ist. Der Gasstrom G verläuft rechtwinklig zum Flüssigkeitsstrom F. Insgesamt bildet sich ein Gesamtstrom S aus, der in Richtung der Achse der Düse 1 verläuft. In diesem Gasstrom S befindet sich die zu feinen Nebeltröpfchen zerrissene Flüssigkeit, die durch den Spalt 2 nach dem Venturi-Prinzip herausgesaugt wurde. Durch Variation der Öffnungszeiten des Spaltes 2 lässt sich der Flüssigkeitsaustritt volumenmäßig dosieren.

Das durch den Strömungskanal 3 tretende Gas wurde in der Heizung 11 vorgeheizt. Dies hat zur Folge, dass sich die Nebeltröpfchen innerhalb des Gasstroms S zufolge ihrer großen Oberfläche schnell erwärmen. Eine Verdampfung findet statt, bevor der Gasstrom S gegen eine heiße Oberfläche trifft.

Wird bei einer Variation der Erfindung der Gasstrom G nicht vorbeheizt, so kann trotzdem eine Verdampfung der zerstäubten Flüssigkeit innerhalb der Gasphase erfolgen, wenn die Verdampfungskammer geheizt ist. Das in der Verdampfungskammer 4 befindliche Gas, in welchem sich der Nebel verteilt, liefert die erforderliche Wärme, um den Nebel in die Gasform zu bringen.

Das in der Verdampfungskammer 4 erzeugte Gas tritt durch die Öffnungen des Strömungsleitblechs 6 und durch die Öffnungen eines nachgeordneten Strömungsleitgitters 7 in nahezu laminarer Strömung in die Beschichtungskammer 5 ein, wo die metallorganische Komponente nach Zersetzung eine Beschichtung auf der Oberfläche des Substrates 8 hinterlässt.

Die Pulslänge der Öffnungszeit liegt im Bereich von weniger als einer Millisekunde bis zu wenigen Millisekunden.

Alle offenbarten Merkmale sind (für sich) erfindungswesentlich.

## Patentansprüche

1. Verfahren zum Zuführen eines in die Gasform gebrachten flüssigen Ausgangsstoffes zusammen mit einem Gas in einen CVD-Reaktor, mit einer einen quer in einen Gasströmungskanal (3) mündenden Flüssigkeitskanal (2) aufweisenden Düse (1), zur Bildung eines Aerosols, welches durch Wärmezufuhr verdampft, **dadurch gekennzeichnet, dass** die Verdampfungswärme ausschließlich dem Gas entzogen wird.

2. Verfahren nach Anspruch 1, **dadurch gekennzeichnet, dass** die Wärmezufuhr durch Temperieren des Gases erfolgt.

3. Verfahren nach Anspruch 2, **dadurch gekennzeichnet, dass** das durch den Gasströmungskanal (3) strömende Gas temperiert ist.

4. Verfahren nach einem der vorhergehenden Ansprüche, **dadurch gekennzeichnet, dass** das Aerosol von dem durch den Gasströmungskanal (3) strömenden Gasstrom (G) in eine wandbeheizte Verdampfungskammer (4) gebracht wird, wobei der aus der Düse austretende Gasstrom (S) derart frei in die Verdampfungskammer (4) tritt, dass das Aerosol vor Auftreffen des Gasstromes (S) auf eine Kammerwand verdampft ist.

5. Verfahren nach einem der vorhergehenden Ansprüche, **dadurch gekennzeichnet, dass** die Mündung des Flüssigkeitskanals (2) insbesondere pulsweise geöffnet und geschlossen wird.

6. Verfahren nach Anspruch 5, **dadurch gekennzeichnet, dass** die Öffnungszeiten länger dauern als die Geschlossenzeiten.

7. Vorrichtung zum Zuführen eines in die Gasform gebrachten flüssigen Ausgangsstoffes in einen CVD-Reaktor mit einer Gaszuleitung (12) für ein Trägergas, welches Trägergas durch einen Strömungskanal (3) in eine Verdampfungskammer (4) strömt, wobei ein Flüssigkeitskanal (2) einer Düse (1) quer in den Strömungskanal (3) mündet, um eine Flüssigkeit in den Strömungskanal (3) zur Bildung eines Aerosols einzubringen, welches Aerosol durch Wärmezufuhr verdampft, **dadurch gekennzeichnet, dass** ein oder mehrere Düsen (1) einer Verdampfungskammer (4) zugeordnet sind, wobei der das Aerosol transportierende Gasstrom (S) frei in die Verdampfungskammer (4) strömt, wo das Aerosol ausschließlich durch Entzug der Verdampfungswärme aus dem Gas verdampft, wobei zur Zufuhr der Verdampfungswärme eine Gasheizung (11) in der Zuleitung (12) und/oder eine geheizte Verdampfungskammer (4) vorgesehen ist, wobei die Verdampfungskammer (4) und eine Beschichtungskammer (5) lediglich durch strömungsleitende Bleche (6) bzw. Gitter (7) voneinander getrennt sind.

8. Vorrichtung nach Anspruch 7, **dadurch gekennzeichnet, dass** die Verdampfungskammer (4) wandbeheizt ist.

9. Vorrichtung nach einem der vorhergehenden Ansprüche, **gekennzeichnet durch** eine der Düse (1) vorgeordnete Gasheizung (11).

10. Vorrichtung nach einem der vorhergehenden Ansprüche, **dadurch gekennzeichnet, dass** der Flüssigkeitskanal pulsweise öffen- und schließbar ist.

11. Vorrichtung nach Anspruch 10, **dadurch gekennzeichnet, dass** der Flüssigkeitskanal (2) ein Ringspalt ist.

12. Vorrichtung nach einem der vorhergehenden Ansprüche, **dadurch gekennzeichnet, dass** der Flüssigkeitskanal (2) eine Konusform besitzt und eine Spaltwand des Flüssigkeitskanals (2) von einem kegelstumpfförmigen Ventilkegel (16) gebildet ist.

13. Vorrichtung nach einem der vorhergehenden Ansprüche, **dadurch gekennzeichnet, dass** der Flüssigkeitskanal (2) von einem ringförmigen Strömungskanal (3) umgeben ist.

14. Vorrichtung nach einem der vorhergehenden Ansprüche, **dadurch gekennzeichnet, dass** die Mündung des Strömungskanals (3) auf einem in der Symmetrieachse des Flüssigkeitskanals liegenden gedachten Punkt (P) gerichtet ist.

15. Vorrichtung nach einem der vorhergehenden Ansprüche, **gekennzeichnet durch**, eine der Verdampfungskammer (4) unmittelbar angegliederte Beschichtungskammer (5).

16. Vorrichtung nach einem der vorhergehenden Ansprüche, **dadurch gekennzeichnet, dass** die Verdampfungskammer (4) und die Beschichtungskammer (5) lediglich durch die die Gasströmung homogenisierende Leitorgane (6, 7) voneinander getrennt sind.

17. Vorrichtung nach einem der vorhergehenden Ansprüche, **dadurch gekennzeichnet, dass** die Düse (1) flüssigkeitsgekühlt, insbesondere wassergekühlt ist.

18. Vorrichtung nach einem der vorhergehenden Ansprüche, **dadurch gekennzeichnet, dass** mehrere Düsen (1) in eine gemeinsame Verdampfungskammer münden.

19. Vorrichtung nach Anspruch 18, **dadurch gekennzeichnet, dass** mehrere Verdampfungskammern insbesondere mit verschiedenen Kammertemperaturen einer gemeinsamen Substratkammer zugeordnet sind.

20. Vorrichtung nach einem der vorhergehenden Ansprüche, **gekennzeichnet durch** mehrere auf einen gemeinsamen Punkt gerichtete Düsen (1) jeweils für einen metallorganischen Ausgangsstoff zur Abscheidung als ferroelektrische Schicht auf einem Substrat.

## Claims

1. A method for feeding a liquid starting material, which has been brought into the gaseous state, together with a gas, into a CVD reactor, having a nozzle (1), which has a liquid passage (2) opening out transversely into a gas flow passage (3), in order to form an aerosol which is vaporized by the supply of heat, **characterized in that** the heat of vaporization is extracted exclusively from the gas.

2. A method according to Claim 1, **characterized in that** the supply of heat is effected by controlling the temperature of the gas.

3. A method according to Claim 2, **characterized in that** the temperature of the gas flowing through the gas flow passage (3) is controlled.

4. A method according to one of the preceding claims, **characterized in that** the aerosol is transferred by the gas stream (G) flowing through the gas flow passage (3) into a wall-heated vaporization chamber (4), the gas stream (S) which emerges from the nozzle passing freely into the vaporization chamber (4) in such a manner that the aerosol is vaporized before the gas stream (S) comes into contact with a chamber wall.

5. A method according to one of the preceding claims, **characterized in that** the opening of the liquid passage (2) is opened and closed, in particular in pulsed fashion.

6. A method according to Claim 5, **characterized in that** the open times last longer than the closed times.

7. A device for feeding a liquid starting material, which has been brought into the gaseous state, into a CVD reactor, having a gas feed line (12) for a carrier gas, which carrier gas flows through a flow passage (3) into a vaporization chamber (4), a liquid passage (2) of a nozzle (1) opening out transversely into a flow passage (3), in order to introduce a liquid into the flow passage (3) for the formation of an aerosol, which aerosol is vaporized by the supply of heat, **characterized in that** one or more nozzles (1) of a vaporization chamber (4) are associated, the gas flow (S) transporting the aerosol flowing freely into the vaporization chamber (4), where the aerosol is vaporized exclusively by extraction of the heat of vaporization from the gas, a gas heater (11) in the feed line (12) and/or a heated vaporization chamber (4) being provided for delivery of the heat of vaporization, the vaporization chamber (4) and the coating chamber (5) being separated from one another solely by flow-diverting sheets (6) and/or grids (7).

8. A device according to Claim 7, **characterized in that** the vaporization chamber (4) is wall-heated.

9. A device according to one of the preceding claims, **characterized by** a gas heater (11) upstream of the nozzle (1).

10. A device according to one of the preceding claims, **characterized in that** the liquid passage can be opened and closed in pulsed fashion.

11. A device according to Claim 10, **characterized in that** the liquid passage (2) is an annular gap.

12. A device according to one of the preceding claims, **characterized in that** the liquid passage (2) is conical in shape and a gap wall of the liquid passage (2) is formed by a frustoconical valve cone (16).

13. A device according to one of the preceding claims, **characterized in that** the liquid passage (2) is surrounded by an annular flow passage (3).

14. A device according to one of the preceding claims, **characterized in that** the opening of the flow passage (3) is directed at an imaginary point (P) which lies in the axis of symmetry of the liquid passage.

15. A device according to one of the preceding claims, **characterized by** a coating chamber (5) which directly adjoins the vaporization chamber (4).

16. A device according to one of the preceding claims, **characterized in that** the vaporization chamber (4) and the coating chamber (5) are separated from one another only by the diverter members (6, 7) which homogenize the gas flow.

17. A device according to one of the preceding claims, **characterized in that** the nozzle (1) is liquid-cooled, in particular water-cooled.

18. A device according to one of the preceding claims, **characterized in that** a plurality of nozzles (1) open out into a common vaporization chamber.

19. A device according to one of the preceding claims, **characterized in that** a plurality of vaporization chambers in particular with different chamber temperatures are associated with a common substrate chamber.

20. A device according to one of the preceding claims, **characterized by** a plurality of nozzles (1), each for a metallo-organic starting material for deposition as a ferroelectric layer on a substrate, which are directed at a common point.

## Revendications

1. Procédé d'amenée d'une substance de départ liquide, mise sous forme gazeuse, conjointement avec un gaz dans un réacteur CVD, au moyen d'une buse (1) comportant un canal de liquide (2) débouchant transversalement dans un canal d'écoulement de gaz (3), afin de former un aérosol qui se vaporise par apport de chaleur, **caractérisé en ce que** la chaleur de vaporisation est exclusivement retirée au gaz.

2. Procédé selon la revendication 1, **caractérisé en ce que** l'apport de chaleur est effectué par équilibrage de la température du gaz.

3. Procédé selon la revendication 2, **caractérisé en ce que** le gaz s'écoulant dans le canal d'écoulement de gaz (3) est équilibré en température.

4. Procédé selon l'une des revendications précédentes, **caractérisé en ce que** l'aérosol est amené dans une chambre de vaporisation (4), dont les parois sont chauffées, par le flux de gaz (G) s'écoulant dans le canal d'écoulement de gaz (3), le flux de gaz sortant de la buse (5) entrant librement dans la chambre de vaporisation (4) de sorte que l'aérosol soit vaporisé avant que le flux de gaz (S) ne vienne heurter une paroi de la chambre.

5. Procédé selon l'une des revendications précédentes, **caractérisé en ce que** l'embouchure du canal de liquide (2) est ouverte et fermée en particulier en régime pulsionnel.

6. Procédé selon la revendication 5, **caractérisé en ce que** les temps d'ouverture sont plus longs que les temps de fermeture.

7. Dispositif d'amenée d'une substance de départ liquide, mise sous forme gazeuse, dans un réacteur CVD comportant une conduite d'amenée de gaz (12) destinée à un gaz de support, lequel gaz de support s'écoule par l'intermédiaire d'un canal d'écoulement (3) dans une chambre de vaporisation (4), un canal de liquide (2) d'une buse (1) débouchant transversalement dans le canal d'écoulement (3) pour introduire un liquide dans le canal d'écoulement (3) afin de former un aérosol, lequel aérosol se vaporise par apport de chaleur, **caractérisé en ce qu'**une ou plusieurs buses (1) sont associées à une chambre de vaporisation (4), le flux de gaz (S) qui transporte l'aérosol s'écoulant librement dans la chambre de vaporisation (4) dans laquelle l'aérosol se vaporise exclusivement par retrait de la chaleur de vaporisation provenant du gaz, un dispositif de chauffage de gaz (11) dans la conduite d'amenée (12) et/ou une chambre de vaporisation chauffée (4) étant prévu pour amener la chaleur de vaporisation, la chambre de vaporisation (4) et une chambre de revêtement (5) étant séparées l'une de l'autre seulement par des tôles (6) ou des grilles (7) de guidage d'écoulement.

8. Dispositif selon la revendication 7, **caractérisé en ce que** la chambre de vaporisation (4) est chauffée au niveau de ses parois.

9. Dispositif selon l'une des revendications précédentes, **caractérisé par** un dispositif de chauffage de gaz (11) placé en amont de la buse (1).

10. Dispositif selon l'une des revendications précédentes, **caractérisé en ce que** le canal de liquide peut être ouvert ou fermé en régime pulsionnel.

11. Dispositif selon la revendication 10, **caractérisé en ce que** le canal de liquide (2) est une fente annulaire.

12. Dispositif selon l'une des revendications précédentes, **caractérisé en ce que** le canal de liquide (2) a une forme conique et une paroi de la fente formant le canal de liquide (2) est réalisée par un cône de soupape (16) en forme de cône tronqué.

13. Dispositif selon l'une des revendications précédentes, **caractérisé en ce que** le canal de liquide (2) est entouré par un canal d'écoulement annulaire (3).

14. Dispositif selon l'une des revendications précédentes, **caractérisé en ce que** l'embouchure du canal d'écoulement (3) est dirigée vers un point imaginaire (P) se trouvant dans l'axe de symétrie du canal de liquide.

15. Dispositif selon l'une des revendications précédentes, **caractérisé par** une chambre de revêtement (5) directement rattachée à la chambre de vaporisation (4).

16. Dispositif selon l'une des revendications précédentes, **caractérisé en ce que** la chambre de vaporisation (4) et la chambre de revêtement (5) sont séparées l'une de l'autre simplement par les organes de guidage (6, 7) homogénéisant l'écoulement de gaz.

17. Dispositif selon l'une des revendications précédentes, **caractérisé en ce que** la buse (1) est refroidie par un liquide, en particulier par de l'eau.

18. Dispositif selon l'une des revendications précédentes, **caractérisé en ce que** plusieurs buses (1) débouchent dans une chambre de vaporisation commune.

19. Dispositif selon la revendication 18, **caractérisé en ce que** plusieurs chambres de vaporisation sont associées, en particulier à différentes températures de chambre, à une chambre de substrat commune.

20. Dispositif selon l'une des revendications précédentes, **caractérisé par** plusieurs buses (1) qui sont dirigées vers un point commun et qui sont destinées chacune à une substance départ organométallique qui doit être déposée sur un substrat sous la forme d'une couche ferroélectrique.
